# EUROPEAN PATENT SPECIFICATION

(11) **EP 4 040 045 B1**
(45) Date of publication and mention of the grant of the patent: **06.03.2024**
(21) Application number: 22153034.8
(22) Date of filing: 24.01.2022
(51) Int. Cl.: F21V 23/00

(54) **LED POWER SUPPLY**
LED-STROMVERSORGUNG
ALIMENTATION ÉLECTRIQUE DE DEL

(30) Priority: 03.02.2021 CN 202110150924
(43) Date of publication of application: 10.08.2022
(73) Proprietor: Self Electronics Co., Ltd., Ningbo City, Zhejiang 315103 (CN); SELF ELECTRONICS Germany GmbH, 51149 Köln (DE); Lin, Wanjiong, Ningbo City, Zhejiang 315103 (CN)
(72) Inventor: QIAN, Weishu, Ningbo, 315103 (CN); WANG, Qiming, Ningbo, 315103 (CN); WANG, Linji, Ningbo, 315103 (CN); XU, Binjie, Ningbo, 315103 (CN)
(74) Representative: 2K Patentanwälte Blasberg Kewitz & Reichel

(56) References cited:
- EP-A1- 2 803 900
- EP-A1- 3 007 343
- WO-A1-2015/002658
- WO-A2-96/13080
- DE-A1-102013 217 270
- US-B1- 9 408 282

## Description

### Technical Field

The present invention relates to the technical field of driving power supplies, in particular to an LED power supply.

### Background of Invention

An LED power supply is a kind of driving power supply. Miniaturization plays an important role in the further development direction of LED power supplies. The miniaturization of LED power supplies is more difficult as regards the design than the design of ordinary power supplies for reasons of electromagnetic compatibility, especially for dimmable power supplies. The working state and working frequency difference between full power and dimming and light load and low power are quite different. On the other hand, the working frequency range of general EMC inductors and capacitors is relatively fixed, and therefore achieving an electromagnetic compatibility (EMC) design is difficult.

In addition, for compact LED power supplies, in order to solve the heat dissipation problem of power devices, generally the method of potting glue is used, but the potting glue has a certain dielectric constant, which reduces the electromagnetic compatibility of the final product. The following describes a conventional processing method: in order to pass the EMC test standard, the filter inductance and filter capacitor at the input and output side of the circuit are added or increased, and at the same time the distance between the switching power device and the electromagnetic compatibility (EMC) device is increased to suppress high-frequency electromagnetic waves. The disadvantage of the alternative in the form of a metal shield is that the cost of the product will increase a lot, the complexity of the production process will increase, and the size of the product needs to be increased. Therefore, it is not easy to achieve a proper miniaturization, and it is thus difficult to meet market demand.

EP 2 803 900 A1 discloses an LED power supply according to the preamble of claim 1. Provision of a metal shielding tape for enhancing EMC compatibility is not disclosed.

US 9 408 282 B1 discloses a light bulb including electronic circuitry for intelligent home control and in particular a printed circuit board (PCB). Provision of a metal shielding tape for enhancing EMC compatibility is not disclosed.

EP 3 007 343 A1 discloses a power unit for plugging into a mother board. Provision of a metal shielding tape for enhancing EMC compatibility is not disclosed.

### SUMMARY OF THE INVENTION

It is an object of the present invention to provide an LED power supply, that is configured to comply with electromagnetic compatibility (EMC) requirements at low costs and compact size and can be produced efficiently and at low costs.

This problem is solved by an LED power supply as claimed by claim 1. Further advantageous embodiments are the subject-matter of the dependent claims.

### Technical effect of the present invention

The LED power supply of the present invention enables the circuit board to modularized, in particular in the form of a plug-in board, and an efficient three-dimensional layout of the electronic components. A metal shielding tape is provided on the periphery (around the circumference) of the switching unit, so that the electromagnetic interference generated by the switching unit is transferred to the ground wire via the metal shielding tape to thereby reduce the interference with other EMC devices. As compared to conventional products with potting glue, which can only achieve a certain degree of shielding effect to meet the electromagnetic compatibility with standard requirements, the production process of an LED power supply of the present invention can be made simple, and the capacitance value of other components such as filter capacitors can be reduced accordingly. Moreover, a LED power supply with a smaller package size can be accomplished, which can save production and product costs while reducing the space occupied by the components.

### Overview on Drawings

Embodiments of the present invention are described below with reference to the accompanying drawings, wherein:
FIG. 1 is a block diagram of the structure of an LED power supply of the present invention;
FIG. 2 is a block diagram of the structure of the drive control module of a preferred embodiment;
FIG. 3 is a schematic circuit diagram of an LED power supply of the present invention;
FIG. 4 is a schematic diagram of the structure of the circuit board assembly of a preferred embodiment;
FIG. 5 is a schematic diagram showing the three-dimensional structure of the circuit board assembly of a preferred embodiment;
FIG. 6 is a schematic structural diagram of the first sub-board of a preferred embodiment;
FIG. 7 is a schematic structural diagram of the back surface of the first sub-board of a preferred embodiment;
FIG. 8 is a schematic structural diagram of a first sub-board according to another embodiment;
FIG. 9 is a schematic structural diagram of a first sub-board according to another embodiment;
FIG. 10 is a schematic structural diagram of a first sub-board according to another embodiment; and
FIG. 11 is a schematic structural diagram of the back surface of the first sub-board according to another embodiment.

### Detailed Description of Preferred Embodiments

Specific embodiments of the present invention will be further described in detail below with reference to the accompanying drawings. It should be understood that the descriptions of the embodiments of the present invention herein are not intended to limit the protection scope of the present invention.

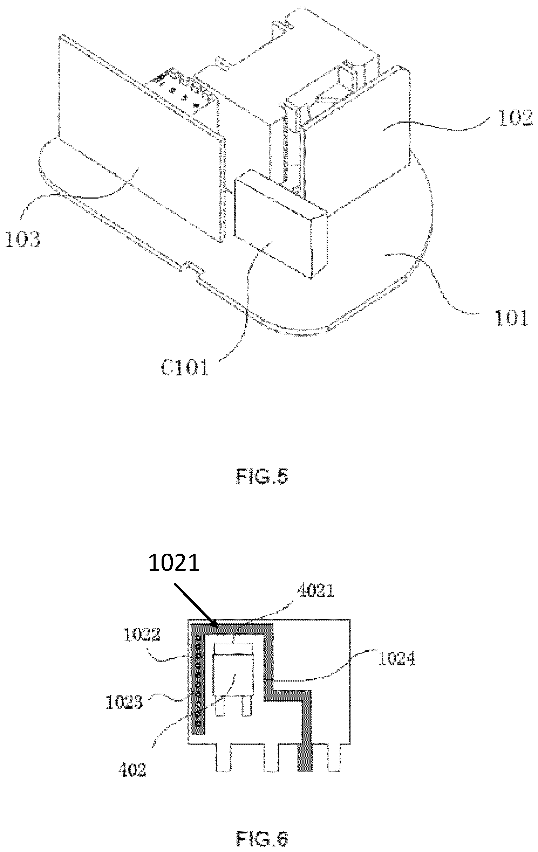

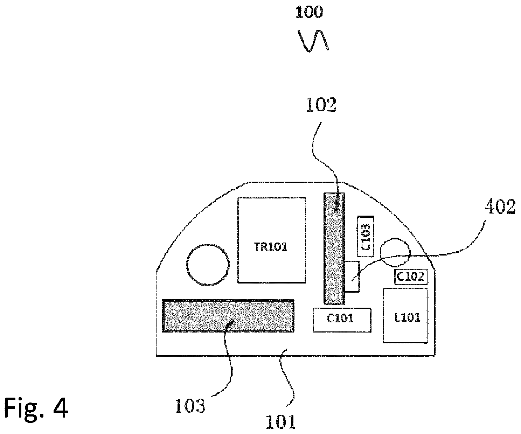

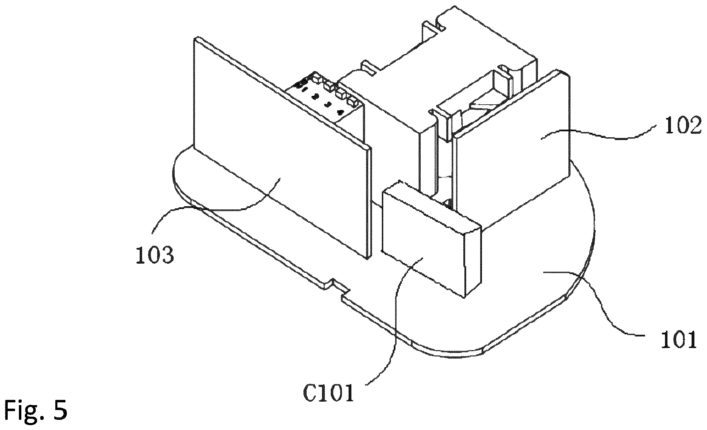

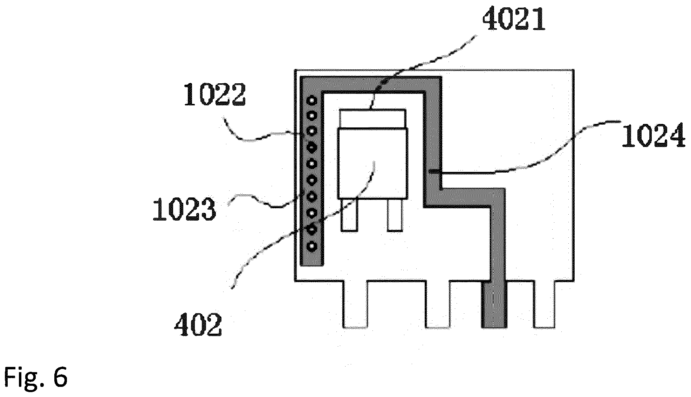

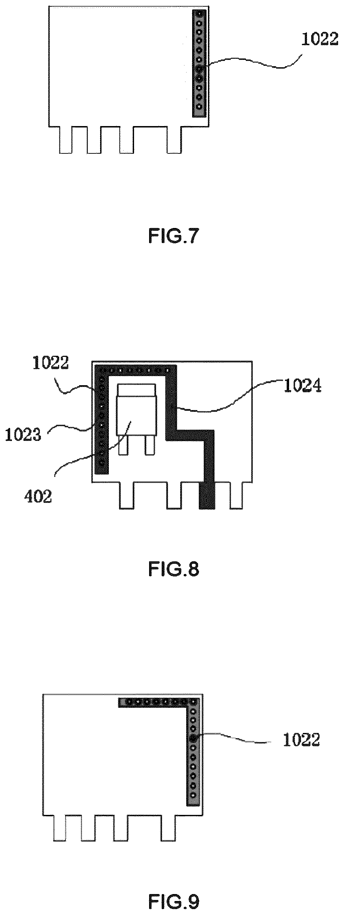

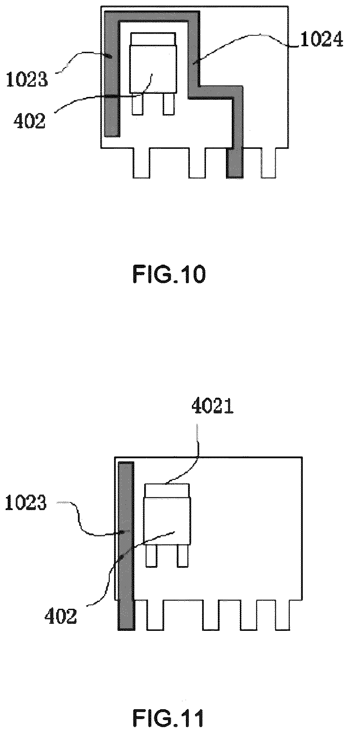

As shown in Figs. 1 to 7, an LED power supply according to the present invention comprises a circuit board assembly 100, and the circuit board assembly 100 is provided with a high-voltage input terminal 200, a rectifier and filter circuit 300, a drive control module 400, a voltage step-down (circuit) 500 (step-down transformer), a DC-DC line (circuit) 600 and an LED connection terminal 700, which are electrically connected in series. The power supply of the present invention uses a printed circuit board to realize the electrical connection of each module and the electronic components of the circuit. How to arrange the above-mentioned modules and circuits on the circuit board is basically known from the prior art and will not be described in detail in the following.

The LED power supply according to the prior art comprises the above-mentioned high-voltage input terminal 200, a rectifier and filter circuit 300, a drive control module 400, a step-down transformer 500, a DC-DC line (circuit) 600 and an LED connection terminal 700. The specific circuits and mutual connection methods are basically known from the prior art, and can use existing circuits and lines, so that their description is not repeated here again.

The LED power supply further comprises a housing for disposing the circuit board assembly 100, which is again basically known from the prior art and will not be described in detail in the following.

The drive control module 400 comprises at least a control unit 401 and a switching unit 402. The circuit board assembly 100 comprises a main board 101 and at least one first sub-board 102 electrically connected to the main board 101, which are arranged perpendicular to each other. The drive control module 400 is provided on the first sub-board 102, and the electrical connection is realized by means of a plug-in board, which facilitates automatic production, and mutual vertical arrangement in order to implement a three-dimensional arrangement.

The circuit board assembly 100 comprises a second sub-board 103 that is electrically connected to the main board 101, and the two boards are arranged perpendicular to each other. The second sub-board 103 is provided with a DC-DC circuit (line) 600.

The DC-DC line 600 is electrically connected with a dimming control module 800, and the dimming control module 800 and the DC-DC line 600 are arranged on the same sub-board 102.

The first sub-board 102 and the second sub-board 103 can adopt the double-sided SMT process, so that the production process is simple, and it is easier to meet the miniaturization requirements on the premise of realizing the product functionality.

The switching unit 401 of the LED power supply has a relatively high operating frequency, which will generate electromagnetic wave interference, such as switching oscillations and multiple high-frequency harmonics, which will adversely affect the surrounding electrical appliances and the environment. Electronic products must meet domestic and international requirements for electromagnetic compatibility. Therefore, it is necessary to design the electromagnetic compatibility compliance of the product, and design filter components and circuits specially for electromagnetic compatibility (EMC). In order to eliminate the above problems, the rectifying and filtering circuit 300 is arranged on the main board 101. The rectifying and filtering circuit 300 includes a plurality of EMC devices.

The core of the switching power supply is the switching unit 401, that is, a power switching device. The switching unit 401 generates a large amount of high-frequency electromagnetic interference when its switching is working. The generated high-frequency electromagnetic interference shall be choked by the EMC devices on the rectifying and filtering circuit 300, such as C101, C102, L101, L102 (not shown in the figure), etc. The specific type and quantity of EMC devices can be selected according to needs. This embodiment is only for demonstration. The above settings are used to reduce electromagnetic interference. The distance between the switching unit 401 and the EMC devices is very close, which will directly affect the effect of the electromagnetic compatibility of the circuit. Especially when the LED power supply is operated with a dimming circuit, the switching frequency varies in a large range, and it is thus difficult for the electromagnetic compatibility circuit to meet the standard requirements. In particular, the average limit curve of the mid-frequency range of 200K~1000KHz in the conduction test has a particularly large impact and is difficult to pass.

From the prior art there are known metal shielding cover solutions. For example, a grounded metal shielding cover can be used for the first sub-board 102 where the switching unit 401 is located to reduce electromagnetic interference, but the process is more complex, which is not conducive to mass production, and the overall cost will also increase a lot.

The invention is aimed at improving the electromagnetic compatibility design of the switching unit 401. A grounded metal shielding tape 1021 is added near the EMC device. The first sub-board 102 is provided with a metal shielding tape 1021 surrounding the switching unit 402. The metal shielding tape 1021 is grounded.

The metal shielding tape 1021 can be single-sided. In order to improve the effect, the metal shielding tape 1021 may also be double-sided, that is, a copper foil and metallized vias can be directly used on the double-sided circuit board, and the electromagnetic interference generated by the switching unit 402 is partially shielded by metal. With the metal shielding tape 1021 lead-in ground wire to reduce interference to other EMC devices, especially products with glue, can achieve a certain degree of shielding effect and meet the requirements of electromagnetic compatibility standards, its production process is simple, and other filter capacitors can be reduced accordingly. The capacitance value of the device can be selected, and a device with a smaller package size can be selected, which can reduce the product costs while reducing the size of the space occupied by components.

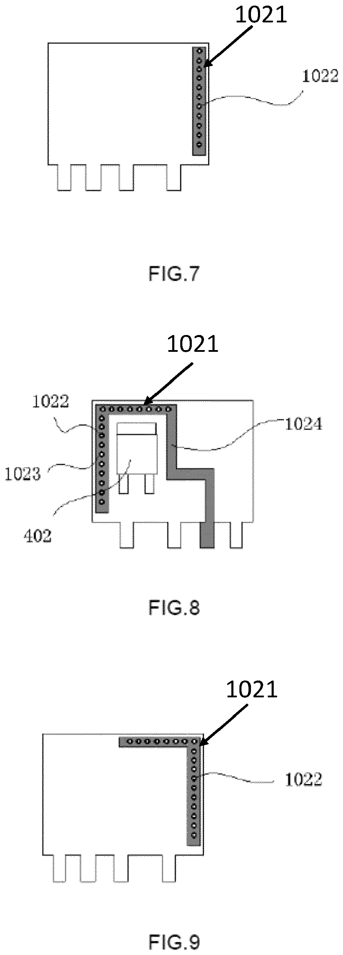

The metal shielding tape 1021 of the invention includes a first segment 1023 extending outward from a position close to the main board 101, and the first segment 1023 is located on a side close to the edge of the first sub-board 102 and passes over the upper edge 4021 of the switching unit 402. The first segment 1023 of the metal shielding tape 1021 is double-sided, and a plurality of metallized via holes 1022 is provided in the area provided on both sides for conduction. The metal shielding tape 1021 of this embodiment further includes a second segment 1024 connected to the end of the first segment 1023 and continuing to surround the switching unit 402. The second segment 1024 is set single-sided, generally, as long as there is enough area on the back side. A double-sided configuration may be provided because the shielding effect of the double-sided configuration is better, but since the circuit arrangement position is not enough, the second segment 1024 its configuration can be selected as required. As shown in Fig. 8, in another embodiment, only the first segment 1023 is provided and it is single-sided.

As shown in Fig. 9, in another embodiment, the first segment 1023 and the second segment 1024 are provided and are single-sided.

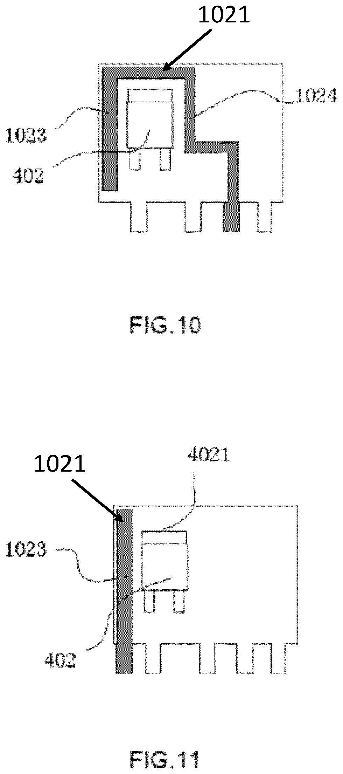

As shown in Figs. 10 and 11, in another embodiment, the first segment 1023 and the second segment 1024 are provided, the first segment 1023 is double-sided, and the front segment of the second segment 1024 is also double-sided, whereas the rear segment is single-sided, and the rear segment of the second segment 1024 is grounded.

The switching unit 402 is a power switching tube (transistor) device. In this embodiment, a MOS tube (transistor) is used, but a triode may also be used.

Through the above arrangement, the distance between the EMC device closest to the rectifier and filter circuit 300 and the first sub-board 102 may be less than 5 mm from the first sub-board 102, so that the circuit board assembly 100 is compact as a whole.

The above description only relates to preferred embodiments of the present invention, and it is thus not intended to delimit the scope of protection of the present invention.

## Claims

1. An LED power supply, comprising a circuit board assembly (100), which is provided with a high-voltage input terminal (200), a rectifier and filter circuit (300), a drive control module (400), a step-down transformer (500), a DC-DC line (600) and an LED connection terminal (700) that are electrically connected in series, wherein the drive control module (400) comprises at least a control unit (401) and a switching unit (402), wherein
the circuit board assembly (100) comprises a main board (101) and at least one first sub-board (102) that is electrically connected to the main board (101),
the main board (101) and the at least one first sub-board (102) are perpendicular to each other,
the first sub-board (102) is provided with the drive control module (400), and
the rectifier and filter circuit (300) is provided on the main board (101) and comprises a plurality of EMC devices;
**characterized in that**
the first sub-board (102) is provided with a metal shielding tape (1021) which is arranged around the switching unit (402) and grounded, wherein
the metal shielding tape (1021) comprises at least a first segment (1023) extending outward from a position close to the main board (101), which is located on a side close to the edge of the first sub-board (102) and is at least flush with the upper edge (4021) of the switching unit (402).

2. The LED power supply according to claim 1, wherein the circuit board assembly (100) comprises a second sub-board (103) electrically connected to the main board (101), wherein the main board (101) and the second sub-board (103) are perpendicular to each other and the second sub-board (103) is provided with DC-DC circuit (lines) (600).

3. The LED power supply according to claim 2, wherein the DC-DC circuit (600) is electrically connected with a dimming control module (800), and wherein the dimming control module (800) and the DC-DC circuit (600) are arranged on the same sub-board (102).

4. The LED power supply according to any of the preceding claims, wherein the metal shielding tape (1021) is single-sided.

5. The LED power supply according to any of claims 1 to 3, wherein the metal shielding tape (1021) is at least partially double-sided, and at least one metalized, conductive via hole (1022) is provided in the area provided on both sides.

6. The LED power supply according to claim 5, wherein the metal shielding tape (1021) includes a first segment (1023) extending outward from a position close to the main board (101).

7. The LED power supply according to claim 6, wherein the first segment (1023) is located on a side close to an edge of a first sub-board (102) and passes over the upper edge (4021) of the switching unit (402).

8. The LED power supply according to claim 6 or 7, wherein the metal shielding tape (1021) further comprises a second segment (1024).

9. The LED power supply according to claim 8, wherein the second segment (1024) is connected to the end of the first segment (1023) and continues to surround the switching unit (402).

10. The LED power supply according to claim 8, wherein the second segment (1024) is single-sided.

11. The LED power supply according to claim 8, wherein the first segment is double-sided, a front segment of the second segment (1024) is double-sided and a rear segment of the second segment (1024) is single-sided and grounded.

12. The LED power supply according to any of the preceding claims, wherein the switching unit (402) uses MOS transistor devices.

13. The LED power supply according to any of the preceding claims, wherein a distance between an EMC-device closest to the rectifier and filter circuit (300) and the first sub-board (102) is less than 5 mm.

## Patentansprüche

1. LED-Stromversorgung, umfassend eine Leiterplattenbaugruppe (100), die mit einer Hochspannungseingangsklemme (200), einer Gleichrichter- und Filterschaltung (300), einem Ansteuerungsmodul (400), einem Abwärtstransformator (500), einer Gleichstrom-Gleichstrom-Leitung (600) und einer LED-Anschlussklemme (700) versehen ist, die elektrisch in Reihe geschaltet sind, wobei das Ansteuerungsmodul (400) mindestens eine Steuereinheit (401) und eine Schalteinheit (402) umfasst, wobei
die Leiterplattenanordnung (100) eine Hauptplatine (101) und mindestens eine erste Teilplatine (102) umfasst, die elektrisch mit der Hauptplatine (101) verbunden ist,
die Hauptplatine (101) und die mindestens eine erste Teilplatine (102) senkrecht zueinander angeordnet sind,
die erste Teilplatine (102) mit dem Ansteuerungsmodul (400) versehen ist, und
die Gleichrichter- und Filterschaltung (300) auf der Hauptplatine (101) vorgesehen ist und eine Mehrzahl von EMV-Vorrichtungen umfasst;
**dadurch gekennzeichnet, dass**
die erste Teilplatine (102) mit einem metallischen Abschirmungsband (1021) versehen ist, das um die Schalteinheit (402) herum angeordnet und geerdet ist, wobei
das metallische Abschirmungsband (1021) mindestens ein erstes Segment (1023) umfasst, das sich von einer Position in der Nähe der Hauptplatine (101), die sich auf einer Seite in der Nähe des Rands der ersten Teilplatine (102) befindet und mindestens mit dem oberen Rand (4021) der Schalteinheit (402) bündig ist, nach außen erstreckt.

2. LED-Stromversorgung nach Anspruch 1, wobei die Leiterplattenanordnung (100) eine zweite Teilplatine (103) umfasst, die elektrisch mit der Hauptplatine (101) verbunden ist, wobei die Hauptplatine (101) und die zweite Teilplatine (103) senkrecht zueinander angeordnet sind und die zweite Teilplatine (103) mit einer Gleichstrom-Gleichstrom-Schaltung (Leitungen) (600) versehen ist.

3. LED-Stromversorgung nach Anspruch 2, wobei die Gleichstrom-Gleichstrom-Schaltung (600) elektrisch mit einem Dimm-Steuermodul (800) verbunden ist, und wobei das Dimm-Steuermodul (800) und die Gleichstrom-Gleichstrom-Schaltung (600) auf derselben Teilplatine (102) angeordnet sind.

4. LED-Stromversorgung nach einem der vorhergehenden Ansprüche, wobei das Metall-Abschirmungsband (1021) einseitig ist.

5. LED-Stromversorgung nach einem der Ansprüche 1 bis 3, wobei das Metall-Abschirmungsband (1021) zumindest abschnittsweise doppelseitig ist und mindestens ein metallisiertes, leitendes Durchgangsloch (1022) in dem beidseitig vorgesehenen Bereich vorgesehen ist.

6. LED-Stromversorgung nach Anspruch 5, wobei das Metall-Abschirmungsband (1021) ein erstes Segment (1023) aufweist, das sich von einer Position in der Nähe der Hauptplatine (101) nach außen erstreckt.

7. LED-Stromversorgung nach Anspruch 6, wobei sich das erste Segment (1023) auf einer Seite in der Nähe eines Rands einer ersten Teilplatine (102) befindet und über den oberen Rand (4021) der Schalteinheit (402) verläuft.

8. LED-Stromversorgung nach Anspruch 6 oder 7, wobei das Metall-Abschirmungsband (1021) ferner ein zweites Segment (1024) umfasst.

9. LED-Stromversorgung nach Anspruch 8, wobei das zweite Segment (1024) mit dem Ende des ersten Segments (1023) verbunden ist und weiterhin die Schalteinheit (402) umgibt.

10. LED-Stromversorgung nach Anspruch 8, wobei das zweite Segment (1024) einseitig ist.

11. LED-Stromversorgung nach Anspruch 8, wobei das erste Segment doppelseitig ist, ein vorderes Segment des zweiten Segments (1024) doppelseitig ist und ein hinteres Segment des zweiten Segments (1024) einseitig und geerdet ist.

12. LED-Netzteil nach einem der vorhergehenden Ansprüche, wobei die Schalteinheit (402) MOS-Transistorvorrichtungen verwendet.

13. LED-Netzteil nach einem der vorhergehenden Ansprüche, wobei ein Abstand zwischen einer EMV-Vorrichtung, die der Gleichrichter- und Filterschaltung (300) am nächsten ist, und der ersten Teilplatine (102) weniger als 5 mm beträgt.

## Revendications

1. Une alimentation électrique de DEL, comprenant un ensemble de cartes de circuits imprimés (100), qui est pourvu d'une borne d'entrée haute tension (200), d'un circuit de redressement et de filtrage (300), d'un module de commande d'entraînement (400), d'un transformateur abaisseur (500), d'une ligne DC-DC (600) et d'une borne de connexion de DEL (700) qui sont électriquement connectés en série, dans lequel le module de commande d'entraînement (400) comprend au moins une unité de commande (401) et une unité de commutation (402), dans lequel
l'ensemble de cartes de circuits imprimés (100) comprend une carte principale (101) et au moins une première carte secondaire (102) qui est connectée électriquement à la carte principale (101),
la carte principale (101) et au moins une première carte secondaire (102) sont perpendiculaires l'une à l'autre,
la première carte secondaire (102) est équipée du module de commande d'entraînement (400), et
le circuit de redressement et de filtrage (300) est prévu sur la carte principale (101) et comprend plusieurs dispositifs CEM ;
**caractérisé par le fait que**
la première carte secondaire (102) est pourvue d'un ruban de blindage métallique (1021) disposé autour de l'unité de commutation (402) et mis à la terre, dans lequel
le ruban de blindage métallique (1021) comprend au moins un premier segment (1023) s'étendant vers l'extérieur à partir d'une position proche de la carte principale (101), qui est située sur un côté proche du bord de la première carte secondaire (102) et qui est au moins au même niveau que le bord supérieur (4021) de l'unité de commutation (402).

2. L'alimentation électrique de DEL selon la revendication 1, dans laquelle l'ensemble de cartes de circuits imprimés (100) comprend une deuxième carte secondaire (103) connectée électriquement à la carte principale (101), la carte principale (101) et la deuxième carte secondaire (103) étant perpendiculaires l'une à l'autre et la deuxième carte secondaire (103) étant pourvue d'un circuit (lignes) DC-DC (600).

3. L'alimentation électrique de DEL selon la revendication 2, dans laquelle le circuit DC-DC (600) est connecté électriquement à un module de commande de gradation (800), et dans laquelle le module de commande de gradation (800) et le circuit DC-DC (600) sont disposés sur la même carte secondaire (102).

4. L'alimentation électrique de DEL selon l'une quelconque des revendications précédentes, dans laquelle le ruban de blindage métallique (1021) est à une seule face.

5. L'alimentation électrique de DEL selon l'une quelconque des revendications 1 à 3, dans laquelle le ruban de blindage métallique (1021) est au moins partiellement double face, et au moins un trou de passage conducteur métallisé (1022) est prévu dans la zone prévue sur les deux faces.

6. L'alimentation électrique de DEL selon la revendication 5, dans laquelle le ruban de blindage métallique (1021) comprend un premier segment (1023) s'étendant vers l'extérieur à partir d'une position proche de la carte principale (101).

7. L'alimentation électrique de DEL selon la revendication 6, dans laquelle le premier segment (1023) est situé sur un côté proche d'un bord d'une première carte secondaire (102) et passe sur le bord supérieur (4021) de l'unité de commutation (402).

8. L'alimentation électrique de DEL selon la revendication 6 ou 7, dans laquelle le ruban de blindage métallique (1021) comprend en outre un deuxième segment (1024).

9. L'alimentation électrique de DEL selon la revendication 8, dans laquelle le deuxième segment (1024) est relié à l'extrémité du premier segment (1023) et continue à entourer l'unité de commutation (402).

10. L'alimentation électrique de DEL selon la revendication 8, dans laquelle le deuxième segment (1024) est à simple face.

11. L'alimentation électrique de DEL selon la revendication 8, dans laquelle le premier segment est double face, un segment avant du deuxième segment (1024) est double face et un segment arrière du deuxième segment (1024) est simple face et mis à la terre.

12. L'alimentation électrique de DEL selon l'une quelconque des revendications précédentes, dans laquelle l'unité de commutation (402) utilise des dispositifs à transistors MOS.

13. L'alimentation électrique de DEL selon l'une quelconque des revendications précédentes, dans laquelle une distance entre un dispositif CEM le plus proche du circuit de redressement et de filtrage (300) et la première carte secondaire (102) est inférieure à 5 mm.
